# EUROPEAN PATENT SPECIFICATION

(11) **EP 1 544 043 B1**
(45) Date of publication and mention of the grant of the patent: **17.10.2007**
(21) Application number: 04257781.7
(22) Date of filing: 15.12.2004
(51) Int. Cl.: B60R 16/02, B60K 37/00, H05K 7/02

(54) **Electrical junction box**
Elektrischer Anschlusskasten
Boîtier de connexion électrique

(30) Priority: 17.12.2003 JP 2003419349
(43) Date of publication of application: 22.06.2005
(73) Proprietor: YAZAKI CORPORATION, Minato-ku Tokyo 108-8333 (JP)
(72) Inventor: Yamamoto, Tetsuya, Ogasa-gun Shizuoka (JP)
(74) Representative: Brunner, Michael John

(56) References cited:
- EP-A- 1 010 583
- US-A- 5 099 396
- US-A- 5 353 190
- US-A- 5 895 277
- PATENT ABSTRACTS OF JAPAN vol. 2003, no. 07, 3 July 2003 (2003-07-03) -& JP 2003 087933 A (AUTO NETWORK GIJUTSU KENKYUSHO:KK; SUMITOMO WIRING SYST LTD; SUMITOMO), 20 March 2003 (2003-03-20)

## Description

This invention relates to an electrical junction box located at a rear side of an on-vehicle device having electronic parts mounted thereon, and more particularly to an electrical junction box located at a rear side of an on-vehicle instrument including a speedometer.

In recent years, electrical junction boxes (called a junction block or a junction box), containing a branch connector of a wire harness, functional circuits, etc., are mounted in a vehicle. Most of such electrical junction boxes contain a large-current circuit for transferring large current supplied as electric power from an alternator or a battery, and a small-current circuit for transferring small current as data signals and control signals. Among such electrical junction boxes, there is the type which is located within an instrument panel, and more specifically is disposed in proximity to a rear face of an on-vehicle instrument (see Japanese Utility Model Publication No. 5-15355U).

However, when the electrical junction box is located in proximity to the rear face of the on-vehicle instrument as described above, there is a possibility that spike noises and others, generated at the time of turning on/off of a switch of the large-current circuit, adversely affect the on-vehicle instrument. Particularly, among the on-vehicle instruments, there are a speedometer and functional circuit which execute processing to provide important information relating to the vehicle. Therefore, it is necessary to beforehand take a measure to cope with such noises.

The above publication teaches that there is provided a shielding structure in which bus bars for a large-current circuit are sandwiched between insulating boards each containing a shielding layer, thereby suppressing the affection of noises due to large current. In this case, however, the electrical junction box is increased in size, and is complicated in construction because of the provision of the shielding structure, so that the cost increases.

It is therefore an object of this invention to provide an electrical junction box which can positively reduce adverse effects of spike noises and others without complicating its construction.

JP 2003-087933 A discloses an electrical junction box, comprising:
a first insulating board, located at a rear side of an on-vehiclel device provided with an electronic component, the first insulating board having a first face opposing to the on-vehicle device and a second face which is opposite to the first face;
a first circuit, provided on the first face of the first insulating board and including a signal transmission circuit; and
a second circuit, provided on the second face of the first insulating board and including a power transmission circuit.

According to the present invention, such a junction box is characterised by:
a second insulating board, disposed between the on-vehicle device and the first circuit; and
an electric wire, provided on the second insulating board for forming a part of the signal transmission circuit.

With this configuration, since the second circuit in which relatively large current flows is provided on that side remote from the on-vehicle device, adverse effects of spike noises and others can be positively reduced without complicating the construction.

With this configuration, since the second insulating board is provided between the second circuit and the on-vehicle device, the adverse effects of spike noises and others can be further positively reduced.

Here, it is preferable that: each of the first insulating board and the second insulating board is disposed so as to extend in a first direction; and the first insulating board and the second insulating board have a substantially same shape when viewed from a second direction perpendicular to the first direction.

In this case, the front side of the second circuit is covered with at least two insulating boards. Accordingly, the adverse effects of spike noises and others can be further positively reduced.

Preferably, the on-vehicle device is an instrument including a speedometer.

In this case, speed information which is one of important information items concerning the vehicle can be positively supplied to the exterior.

Preferably, the first circuit, the second circuit and the first insulating board constitutes a bus bar unit.

Since the bus bar unit is one of members originally contained in this kind of electrical junction box, the above noise prevention effect can be achieved without the need for using any additional member and without complicating the construction.

The above objects and advantages of the present invention will become more apparent by describing in detail preferred exemplary embodiments thereof with reference to the accompanying drawings, wherein:
Fig. 1 is a schematic perspective view of an electrical junction box according to one embodiment of the invention, showing a state before the electrical junction box is mounted on an on-vehicle instrument;
Fig. 2 is a section view of the electrical junction box, showing a state after the electrical junction box is mounted on the on-vehicle instrument;
Fig. 3 is a perspective view of the electrical junction box, showing a disassembled state thereof; and
Fig. 4 is a section view of an essential portion of the electrical junction box.

One embodiment of the present invention will be described below in detail with reference to the accompanying drawings.

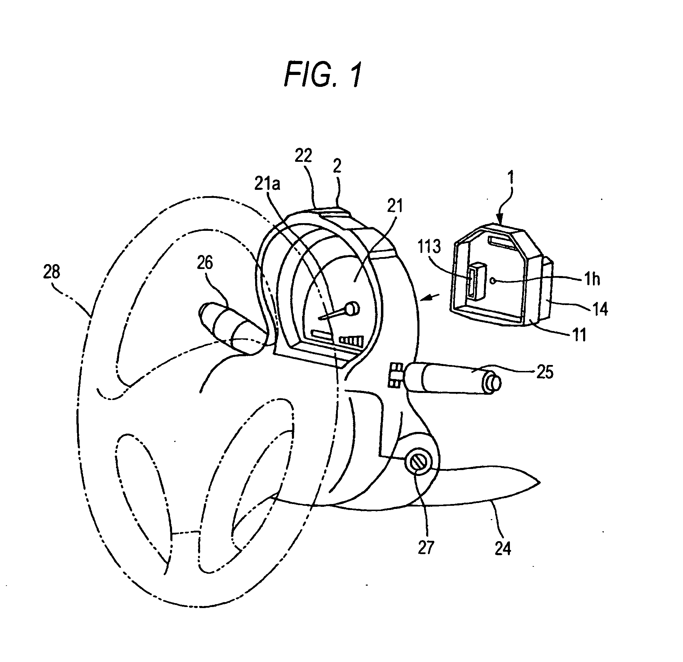

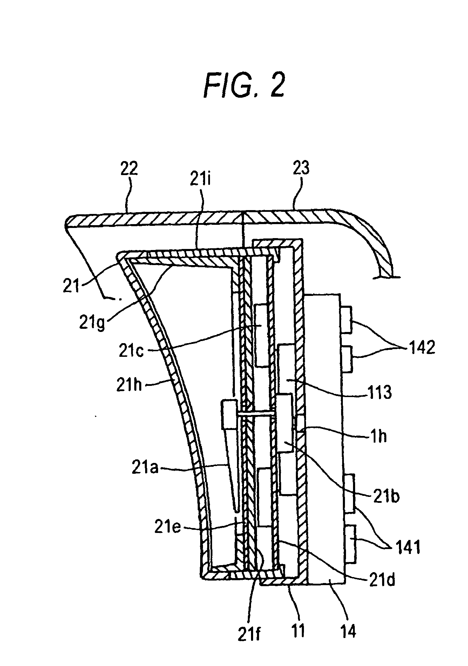

As shown in Figs. 1 and 2, an electrical junction box 1 is mounted on a rear or back side of an instrument 21 fitted in a steering column 2. As is well known, the steering column 2 comprises a front cover 22, a rear cover 23, and a lower cover 24. A turn signal switch 25, a wiper switch 26 and an ignition switch 27 are provided on a side face of the steering column 2, and a steering wheel 28 is mounted on a front side of the steering column 2. Although the instrument 21, illustrated here, is a single-eye meter basically forming a speedometer, it can be replaced by a weft-known combination meter including a speedometer, a tachometer, a temperature indicator, etc.

As is well known, the instrument 21, fitted in the steering column 2, comprises: a base board 21d on which a pointer 21a indicating a speed value, a movement 21b for turning a pointer 21 a, an electronic component 21c such as a microcomputer, a light source element (not shown), etc., are mounted; a dial plate 21e having a design (speed scales and others) formed thereon; a light-guide plate 21f for efficiently guiding light from the light source element to the dial plate 21e; an end plate 21g secured to a front side of the dial plate 21 e; a front glass panel 21 h provided in front of the dial plate 21 e to cover the same; and a casing 21 i, as shown in Fig. 2.

The electrical junction box 1 is mounted on the rear face of the instrument 21, and more specifically on the rear face of the base board 21 d. The electrical junction box 1 is mounted in this position in such a manner that a connector 113, formed on a front face thereof is fitted to a connector (not shown) formed on the rear face of the instrument 21

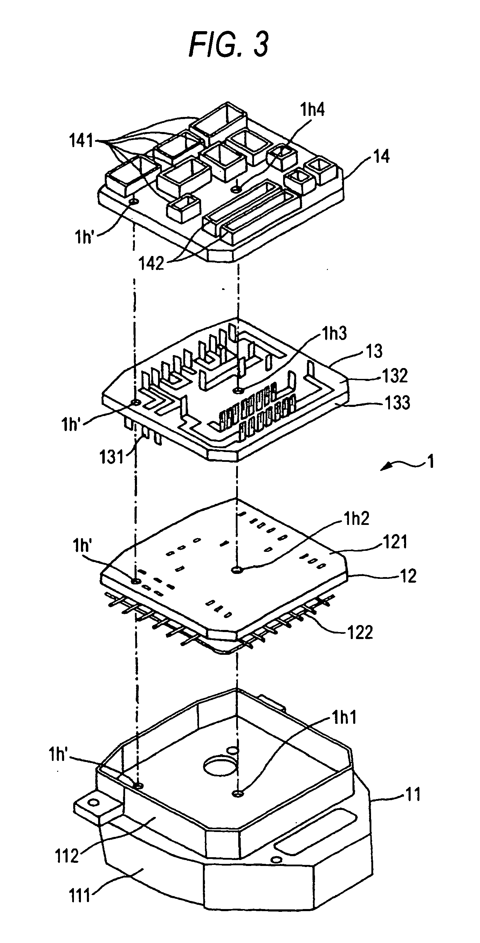

As shown in Fig. 3, the electrical junction box 1 comprises an undercover 11, a wiring unit 12, a bus bar unit 13, and a main cover 14. Although the electrical junction box 1 further includes an electronic circuit section or the like, the showing of these parts is omitted since they are not particularly necessary for the understanding of the subject matter of the invention.

The undercover 11 is made of resin, and includes: a base portion 111 having a generally trapezoidal shape when viewed from the upper side; and a holder 112 having a generally square shape when viewed from the upper side for receiving the wiring unit 12, the bus bar unit 13, etc. A through hole 1h1 is formed through a generally central portion of a bottom of the holder 112, and this through hole 1h1 forms part of the pilot hole 1h

The wiring unit 12 comprises a wiring holder 121, and wires 122 installed on this wiring holder 121. The wiring holder 121 is made of an insulating material such as resin, and has generally the same plan shape (as viewed from the upper side) as a bus bar holder 133 (described later). The disk-shaped wiring holder 121 has a plurality of retainers for retaining the wires 121 in a predetermined position. The wires 122 are connected to small-current bus bars 131 to transfer small current such as data signals and control signals. A through hole 1 h2 is formed through a generally central portion of the wiring holder 121, and this through hole 1h2 forms part of the pilot hole 1 h.

The bus bar unit 13 comprises the small-current bus bars 131, large-current bus bars 132, and the bus bar holder 133.

Each of the small-current bus bars 131 are formed of a metal sheet, and mainly transfer small current such as data signals and control signals of a microcomputer and various electrical circuits. The small-current bus bars 131 have tab-like terminals formed integrally therewith and projecting perpendicularly therefrom. The small-current bus bars 131 is mounted on the bus bar holder 133 in such a manner that the tab-like terminals extend through the bus bar holder 133.

On the other hand, each of the large-current bus bars 132 are formed of a metal sheet, and mainly transfer large current supplied as electric power from an alternator or a battery. The large-current bus bars 132 also have tab-like terminals formed integrally therewith and projecting perpendicularly therefrom. The large-current bus bars 132 is mounted on the bus bar holder 133 in such a manner that the tab-like terminals extend through the bus bar holder 133.

The bus bar holder 133 is made of an insulating material such as resin, and the small-current bus bars 131 and the large-current bus bars 132 are mounted on the opposite sides of the bus bar holder 133, respectively. A through hole 1h3 is formed through a generally central portion of the bus bar holder 133, and this through hole 1 h3 forms part of the pilot hole 1h.

The main cover 14 is made of resin, and when viewed from the upper side, this main cover 14 has a generally square shape corresponding to the shape of the holder 112 of the undercover 11, and is open downwardly (in this figure). A plurality of connector receivers 141 for respectively receiving socket-shaped connectors (not shown), fuse receivers 142 for respectively receiving fuses (not shown), and other portions are formed on an upper face of the main cover 14. A through hole 1h4 is formed through a generally central portion of the main cover 14, and this through hole 1h4 forms part of the pilot hole 1h. In this embodiment, the electrical junction box 1 is provided with another pilot hole 1h'.

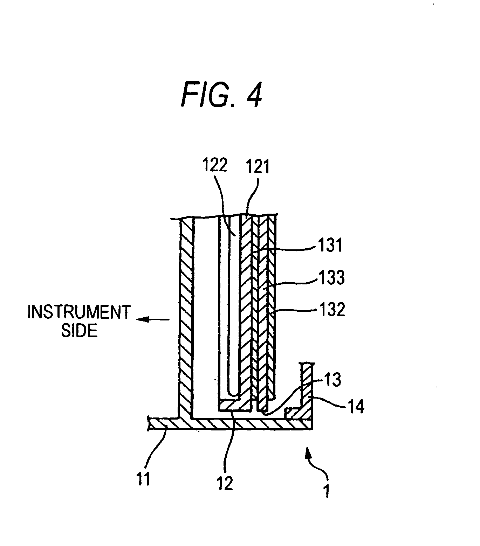

As shown in Fig. 4, the wiring unit 12 and the bus bar unit 13 are arranged in this order from the rear side of the instrument 21 while being covered with the undercover 11 and the main cover 14.

More specifically, the small-current bus bars 131 are laid on that side (face) of the bus bar holder 133 close to the rear face of the instrument 21, while the large-current bus bars 132 are laid on that side (face) of the bus bar holder 133 facing away from the small-current bus bars 131, that is, remote from the rear face of the instrument 21. The wiring unit 12, including the wiring holder 121 having the wires 122 installed thereon, is disposed closer to the rear face of the instrument 21 (than the bus bars 131 and 132) in generally parallel relation to the bus bars 131 and 132. Namely, the wiring holder 121, the small-current bus bars 131, the bus bar holder 133 and the large-current bus bars 132 are arranged in this order from the rear face of the instrument 21.

Since the small-current bus bars 131 are laid on that side of the bus bar holder 133 close to the rear face of the instrument 21, while the large-current bus bars 132 are laid on that side of the bus bar holder 133 facing away from the small-current bus bar 131', that is, remote from the rear face of the instrument 21, adverse effects of spike noises and others, generated at the time of turning on/off of a switch in the large-current circuit, on the instrument can be positively reduced. And besides, since the wiring unit 12 is disposed closer to the rear face of the instrument 21, the adverse effects on the instrument can be more positively reduced. Furthermore, since the bus bar holder 133 and the wiring holder 121 have generally the same shape, and are disposed parallel to each other, the front side of the large-current bus bars 132, directed toward the rear face of the instrument 21, is completely covered at least with the two insulating plates, so that adverse effects of spike noises and others can be still more positively reduced.

Since the bus bar unit 13 including the bus bar holder 133, and the wiring unit 12, including the wiring holder 121, are members originally contained in this kind of electrical junction box, the above noise prevention effect can be achieved without the need for using any additional member and without complicating the construction. The electrical junction box 1 is located at the rear side of the instrument 21 containing the speedometer, and by doing so, speed information (which is one of important information items concerning the vehicle) can be positively provided to the exterior.

Although the present invention is shown and described with reference, to specific preferred embodiments, various changes and modifications will be apparent to those skilled in the art from the teachings herein.

For example, although the bus bars are used as the large-current circuit and the small-curtent circuit, these circuits are not limited to the bus bars. Although the single-eye meter is illustrated as the instrument, the electrical junction box of the invention can be used with any other suitable device.

## Claims

1. An electrical junction boy (1), comprising:
a first insulating board (133), located at a rear side of an on-vehicle device (21) provided with an electronic component (21 c), the first insulating board having a first face opposing to the on-vehicle device and a second face which is opposite to the first face;
a first circuit (131), provided on the first face of the first insulating board and including a signal transmission circuit; and
a second circuit (132), provided on the second face of the first insulating board and including a power transmission circuit; **characterised by**:
a second insulating board (121), disposed between the on-vehicle device and the first circuit (131); and
an electric wire (122), provided on the second insulating board for forming a part of the signal transmission circuit.

2. The electrical junction box (1) as set forth in claim 1, wherein:
each of the first insulating board (133) and the second insulating board (121) is disposed so as to extend in a first direction; and
the first insulating board and the second insulating board have a substantially same shape when viewed from a second direction perpendicular to the first direction.

3. The electrical junction box (1) as set forth in claim 1, wherein the on-vehicle device (21) is an instrument including a speedometer.

4. The electrical junction box (1) as set forth in claim 1, wherein the first circuit (131), the second circuit (132) and the first insulating board (131) constitutes a bus bar unit (13).

## Patentansprüche

1. Elektrischer Anschlusskasten (1), umfassend:
eine erste Isolierplatte (133), die sich an der Rückseite einer am Fahrzeug befindlichen Vorrichtung (21) befindet, die mit einer elektronischen Komponente (21 c) ausgestattet ist, wobei die erste Isolierplatte eine erste Seite aufweist, die der am Fahrzeug befindlichen Vorrichtung gegenüberliegt, und eine zweite Seite, die der ersten Seite gegenüberliegt;
eine erste Schaltung (131), die auf der ersten Seite der ersten Isolierplatte bereitgestellt ist und eine Signalübertragungsschaltung enthält, und
eine zweite Schaltung (132), die auf der zweiten Seite der ersten Isolierplatte bereitgestellt ist und eine Energieübertragungsschaltung enthält; **gekennzeichnet durch**:
eine zweite Isolierplatte (121), die zwischen der am Fahrzeug befindlichen Vorrichtung und der ersten Schaltung (131) angeordnet ist; und
einen Elektrodraht (122), der auf der zweiten lsolierplatte zum Ausbilden eines Teils der Signalübertragungsschaltung bereitgestellt ist.

2. Elektrischer Anschlusskasten (1) nach Anspruch 1, wobei:
jede der ersten Isolierplatte (133) und der zweiten lsolierplatte (121) so angeordnet ist, dass sie sich in einer ersten Richtung erstreckt; und
die erste Isolierplatte und die zweite Isolierplatte eine im Wesentlichen gleiche Form aufweisen, wenn sie von einer zweiten Richtung aus betrachtet werden, die senkrecht zu der ersten Richtung verläuft.

3. Elektrischer Anschlusskasten (1) nach Anspruch 1, wobei die am Fahrzeug befindliche Vorrichtung (21) ein Instrument ist, das einen Geschwindigkeitsmesser enthält.

4. Elektrischer Anschlusskasten (1) nach Anspruch 1, wobei die erste Schaltung (131), die zweite Schaltung (132) und die erste Isolierplatte (131) eine Stromanschlusseinheit bilden.

## Revendications

1. Boîtier de connexion électrique (1), comprenant :
un premier panneau isolant (133), situé au niveau d'un côté arrière d'un dispositif embarqué (21) muni d'un composant électronique (21c), le premier panneau isolant ayant une première face s'opposant au dispositif embarqué et une deuxième face qui est opposée à la première face ;
un premier circuit (131), disposé sur la première face du premier panneau isolant et comprenant un circuit de transmission de signal ; et
un deuxième circuit (132), disposé sur la deuxième face du premier panneau isolant et comprenant un circuit de transmission de puissance ; **caractérisé par** :
un deuxième panneau isolant (121), disposé entre le dispositif embarqué et le premier circuit (131) ; et
un fil électrique (122), disposé sur le deuxième panneau isolant destiné à former une partie du circuit de transmission de signal.

2. Boîtier de connexion électrique (1) selon la revendication 1, dans lequel :
chaque premier panneau isolant (133) et deuxième panneau isolant (121) est disposé de manière à s'étendre dans une première direction ; et
le premier panneau isolant et le deuxième panneau isolant ont une forme sensiblement identique lorsqu'ils sont vus à partir d'une deuxième direction perpendiculaire à la première direction.

3. Boîtier de connexion électrique (1) selon la revendication 1, dans lequel le dispositif embarqué (21) est un instrument comprenant un indicateur de vitesse.

4. Boîtier de connexion électrique (1) selon la revendication 1, dans lequel le premier circuit (131), le deuxième circuit (132) et le premier panneau isolant (131) constituent une unité de barre omnibus (13).
